# EUROPEAN PATENT APPLICATION

(11) **EP 3 321 181 A1**
(43) Date of publication of application: **16.05.2018**
(21) Application number: 17201567.9
(22) Date of filing: 14.11.2017
(51) Int. Cl.: B64D 13/00, F16K 7/00, B64C 25/42, F16K 15/14, F16K 31/00

(54) **TEMPERATURE ACTUATED PANEL**

(30) Priority: 15.11.2016 US 201615352039
(71) Applicant: The Boeing Company, Chicago, IL 60606-2016 (US)
(72) Inventor: CHRISTMAN, David, Chicago, IL Illinois 60606-2016 (US); QUANDT, Gene, Chicago, IL Illinois 60606-2016 (US)
(74) Representative: Boult Wade Tennant

(57) **Abstract**

An example apparatus includes a wall having an opening and a panel attached to the wall over the opening. The panel includes a shape-memory material (SMM). An example method includes bending the panel away from the wall via the panel at least partially changing from a first crystal phase to a second crystal phase. The panel bends away from the wall in response to a temperature of the panel increasing. The method further includes bending the panel toward the wall via the panel at least partially changing from the second crystal phase to the first crystal phase. The panel bends toward the wall in response to the temperature of the panel decreasing.

## Description

### FIELD

The present disclosure generally relates to systems and methods for opening or closing a panel, and more particularly to systems and methods related to a panel that opens or closes automatically in response to temperature changes.

### BACKGROUND

Vent panels that can be opened or closed may be useful in various situations to regulate heat transfer. For example, it may be desirable to partially enclose an aircraft engine within an engine compartment to direct thrust provided by the engine and to reduce aerodynamic drag during flight. At times, however, heat generated by the engine or other components may cause the temperature within the engine compartment to become high enough to cause damage to the engine or other components or structures within the engine compartment. For example, undesirably high temperatures within the engine compartment may occur while the aircraft is climbing (*e.g*., increasing in altitude). Thus, a vent panel may be used on a wall of the engine compartment. The vent panel may be opened to allow heat to escape from the engine compartment when the temperature within the engine compartment becomes too high, and the vent panel may be closed when the temperature within the engine compartment decreases to an acceptable level. In this way, the vent panel may open to allow heat flow when needed, but may otherwise be closed to preserve an aerodynamic surface of the wall. Vent panels could be used in conjunction with other cavities within the aircraft (*e.g.,* a landing gear compartment) to regulate heat flow as well.

Such a vent panel may be electronically controlled. For example, a heat sensor may be placed near or on an area of interest, and the vent panel may be opened or closed based on signals received from the heat sensor. For example, the vent panel may be opened when the heat sensor indicates a temperature that is higher than a threshold value, and the vent panel may be closed when the heat sensor indicates a temperature lower than a threshold value. However, this implementation may involve various electronic hardware and/or software which add cost and complexity.

Accordingly, there is a need for a temperature actuated vent panel that operates independently of other control systems.

### SUMMARY

In one example, an apparatus includes a wall having an opening and a panel attached to the wall over the opening. The panel includes a shape-memory material (SMM) and the panel bends away from the wall in response to an increase in a temperature of the panel and bends toward the wall in response to a decrease of the temperature of the panel.

In another example, a method for actuating a panel is provided. The panel is attached to a wall over an opening in the wall. The method includes bending the panel away from the wall, via the panel at least partially changing from a first crystal phase to a second crystal phase. The panel bends away from the wall in response to a temperature of the panel increasing. The method further includes bending the panel toward the wall, via the panel at least partially changing from the second crystal phase to the first crystal phase. The panel bends toward the wall in response to the temperature of the panel decreasing.

In yet another example, an aircraft includes an engine and a wall having an opening. The wall at least partially surrounds the engine. The aircraft further includes a panel attached to the wall over the opening. The panel comprises a shape-memory material (SMM). The panel bends away from the wall in response to an increase in a temperature of the panel and bends toward the wall in response to a decrease of the temperature of the panel.

The features, functions, and advantages that have been discussed can be achieved independently in various embodiments or may be combined in yet other embodiments further details of which can be seen with reference to the following description and drawings.

Further comprising an aircraft comprising: an engine; a wall having an opening, wherein the wall at least partially surrounds the engine; and a panel attached to the wall over the opening, wherein the panel comprises a shape-memory material (SMM), and wherein the panel bends away from the wall in response to an increase in a temperature of the panel and bends toward the wall in response to a decrease of the temperature of the panel.

### BRIEF DESCRIPTION OF THE DRAWINGS

The novel features believed characteristic of the illustrative embodiments are set forth in the appended claims. The illustrative embodiments, however, as well as a preferred mode of use, further objectives and descriptions thereof, will best be understood by reference to the following detailed description of an illustrative embodiment of the present disclosure when read in conjunction with the accompanying Figures.
Figure 1 illustrates an inner side of an example apparatus, according to an example embodiment.
Figure 2 illustrates an outer side of an example apparatus with a panel removed, according to an example embodiment.
Figure 3 illustrates an outer side of an example apparatus with a panel attached and in a closed position, according to an example embodiment.
Figure 4 illustrates a panel of an example apparatus in an open position, according to an example embodiment.
Figure 5 illustrates a panel of an example apparatus in a closed position, according to an example embodiment.
Figure 6 illustrates a panel of an example apparatus in an open position, according to an example embodiment.
Figure 7 illustrates a panel of an example apparatus in a closed position, according to an example embodiment.
Figure 8 is a schematic diagram of an example aircraft, according to an example embodiment.
Figure 9 illustrates an example apparatus forming a portion of an engine compartment, according to an example embodiment.
Figure 10 illustrates an example apparatus forming a portion of a landing gear compartment, according to an example embodiment.
Figure 11 illustrates an example apparatus forming a portion of a landing gear compartment, according to an example embodiment.
Figure 12 illustrates an example apparatus forming a portion of a landing gear compartment, according to an example embodiment.
Figure 13 illustrates an example apparatus forming a portion of a landing gear compartment, according to an example embodiment.
Figure 14 is a block diagram of a method, according to an example embodiment.
Figure 15 is a block diagram of another method, according to an example embodiment.

### DETAILED DESCRIPTION

Within examples, a temperature actuated panel may be attached over an opening in a wall or another structure. Generally, the panel may be attached over an opening in any wall that is near a heat source or near areas where undesirable amounts of heat are prone to build up. The wall may be part of an engine compartment or a landing gear compartment (e.g., a wheel well) of an aircraft, but other examples are possible. When the panel opens, heat may flow through the opening from one side of the wall to the other, perhaps reducing the temperature of structures or components behind the wall. When the panel closes, heat flow may be restricted, but the panel may conform to an aerodynamic surface of the wall.

The panel may be formed from a shape-memory material (SMM) such as a shape-memory alloy or a shape-memory polymer. The SMM may include a copper-aluminum-nickel alloy, a nickel-titanium alloy (e.g., nitinol), or another type of SMM. The SMM of the panel may generally include any material that can change crystal phase in response to increasing and/or decreasing temperature. That is, the atoms making up the SMM may arrange themselves differently depending on the temperature of the SMM. As an example, a nickel-titanium alloy may form a simple cubic structure within a high temperature range and a body-centered tetragonal structure within a lower temperature range. Such changes in crystal phase may cause the SMM to bend away from or toward the wall.

For instance, the panel may bend away from the wall by at least partially changing from a first crystal phase to a second crystal phase in response to a temperature of the panel increasing (e.g., exceeding a threshold temperature). More specifically, the panel may bend away from the wall to open a path or widen a path for a fluid (*e.g.,* air) to flow through the opening. The panel may also bend back toward the wall by at least partially changing from the second crystal phase to the first crystal phase in response to the temperature of the panel decreasing (*e.g*., decreasing to be less than a threshold temperature). The panel may bend toward the wall to seal the opening, become flush with a surface of the wall, or narrow a path for the fluid to flow through the opening. The panel bending back toward the wall may include the panel substantially returning to a position at which the panel assumed prior to the panel bending away from the wall in response to the increase in the temperature of the panel.

Using a SMM as part of a heat transfer system may yield a number of benefits. For example, the SMM may render hardware and/or software based heat detection and control systems unnecessary in that the SMM may be configured to selectively allow heated fluid to flow through the opening in the wall based on the temperature of the SMM. In this setting, heat sensors, hardware or software based control systems, and actuators for moving the panel might not be necessary. In this way, the heat transfer system might not be dependent on proper functioning of a heat sensor or a control system, nor will it consume power.

Disclosed embodiments will now be described more fully hereinafter with reference to the accompanying Drawings, in which some, but not all of the disclosed embodiments are shown. Indeed, several different embodiments may be described and should not be construed as limited to the embodiments set forth herein. Rather, these embodiments are described so that this disclosure will be thorough and complete and will fully convey the scope of the disclosure to those skilled in the art.

By the term "about" or "substantially" with reference to amounts or measurement values described herein, it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

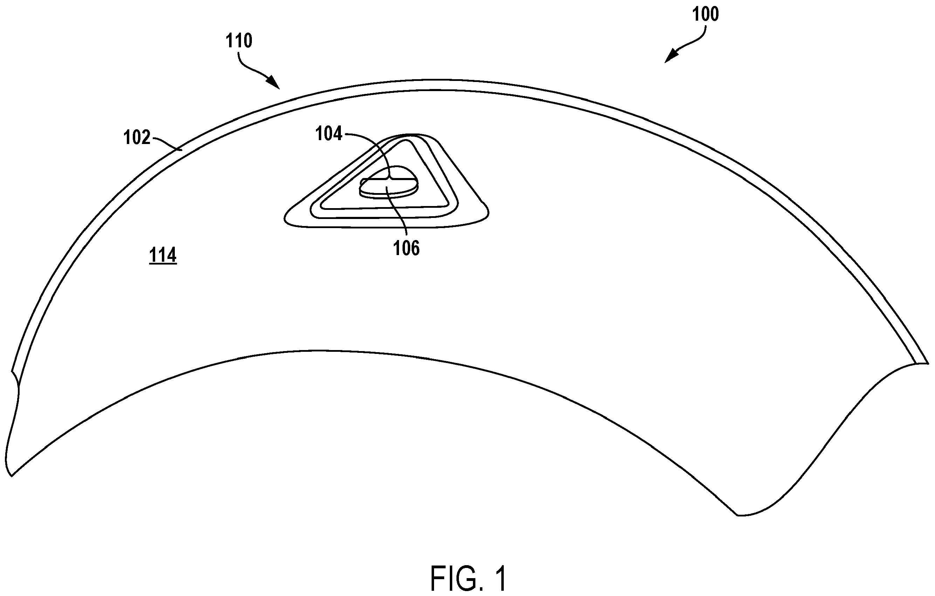

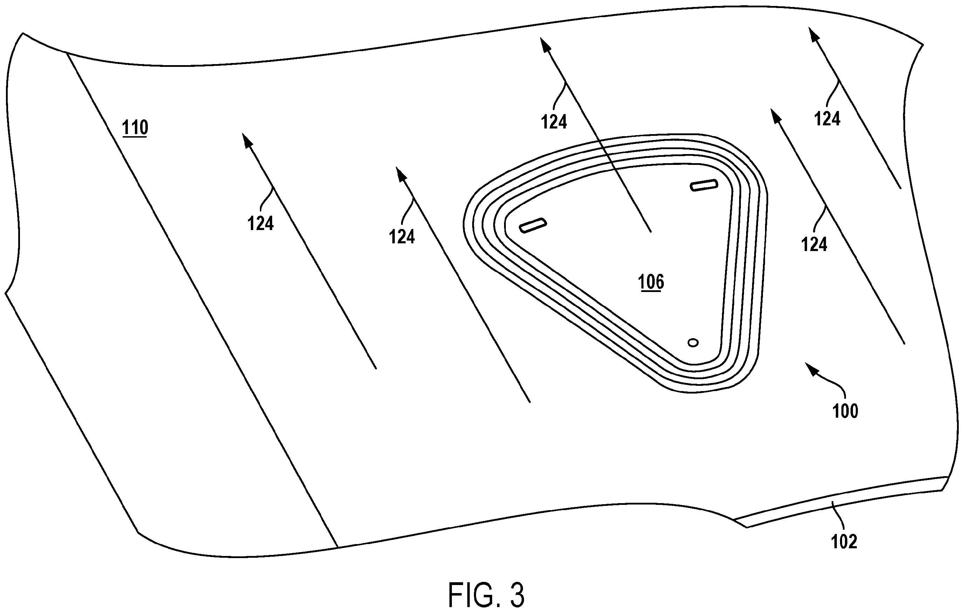

Referring now to Figure 1, the apparatus 100 may include a wall 102, an opening 104 in the wall 102, and a panel 106. Figure 1 is a view of a side 114 of the wall 102. The side 114 may be opposite a side 110 of the wall 102. The apparatus 100 may generally be useful to provide either a path through the opening 104 for heat transfer via fluid flow from the side 114 to the side 110, or an outward-facing aerodynamic surface that includes the panel 106 and the side 110, as shown in Figures 3, 5, and 7.

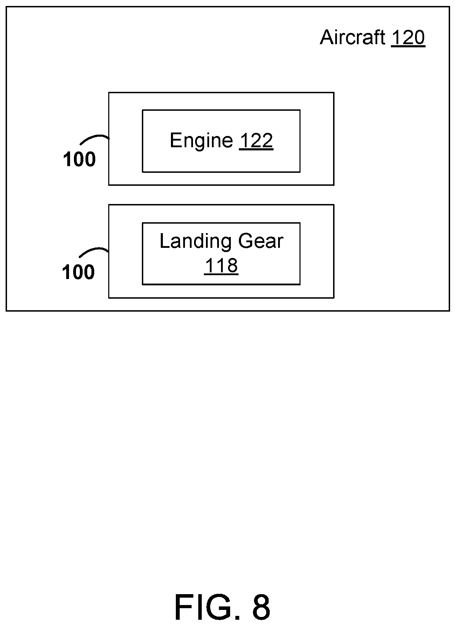

The wall 102 may take various forms. The wall 102 may be part of or form an engine compartment or a landing gear compartment (*e.g*., a wheel well) of an aircraft 120 shown in Figure 8, but other examples are possible. The wall 102 may be formed with materials such as metals, non-metals, plastics (*e.g.*, carbon fiber reinforced plastic), composites, polymers, or any other solid materials.

As shown in Figure 1, the opening 104 may be substantially round, but other examples are possible. The opening 104 may serve as a path for heated fluid on or near the side 114 to flow through to the side 110 of the wall 102. Referring to Figure 8, for example, an engine 122 of the aircraft 120 may generate heat during operation, thereby heating fluid (*e.g.,* air) on or near the side 114. When the panel 106 is in an "open" position, the panel 106 may allow the heated fluid to flow through the opening 104. When the panel 106 is in a "closed" position, the panel 106 may restrict the flow of fluid through the opening 104.

The panel 106 may be attached to the wall 102 over the opening 104. The panel 106 may be attached to the wall 102 via adhesives or fasteners along an outer edge or perimeter of the panel 106, for example. The panel 106 may include or be formed from a shape-memory material (SMM), such as a shape-memory alloy (*e.g.,* a copper-aluminum-nickel alloy, a copper-zinc-aluminum alloy, or a nickel-titanium alloy) or a shape-memory polymer.

Due to being at least partially formed from a SMM, the panel 106 may be configured to bend away from the wall 102 in response to an increase in a temperature of the panel 106 and may be configured to bend back toward the wall 102 in response to a decrease of the temperature of the panel 106.

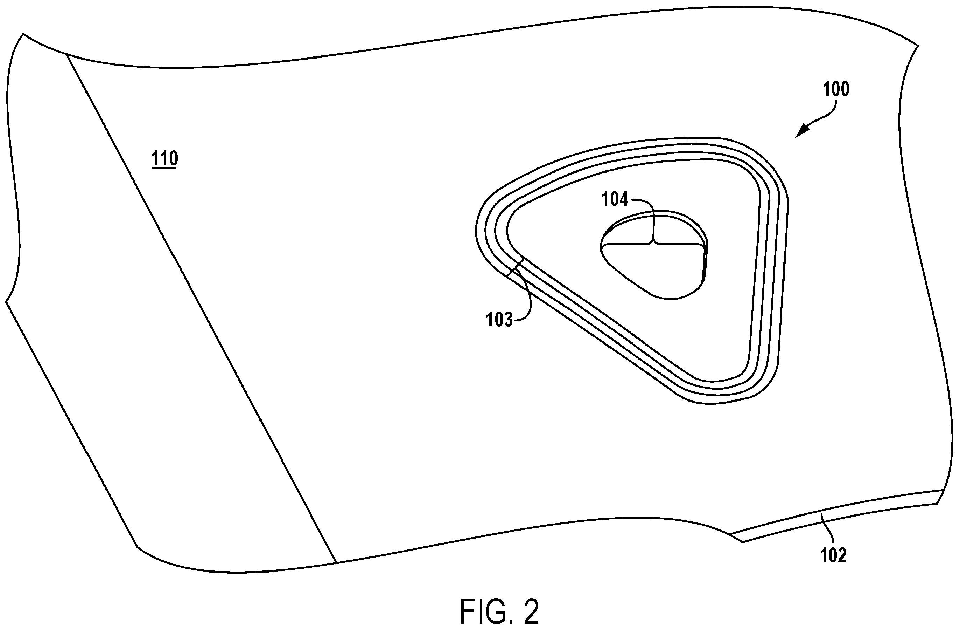

Figure 2 is a view of the side 110 of the wall 102. The panel 106 is omitted in Figure 2 so that the opening 104 may be illustrated. As shown, the wall 102 may include ply drop offs 103 to form a graded surface that allows the panel 106 to form a substantially flush surface with the side 110 of the wall 102. Alternatively, the wall 102 may include a machined recessed region with square edges that accommodate flush mating of the panel 106 with the side 110.

Figure 3 is a view of the side 110 of the wall 102 with the panel 106 attached to the wall 102. The panel 106 is shown in a closed position. The panel 106 may be flush with the side 110 of the wall 102 while in the closed position. When used in conjunction with the aircraft 120, the apparatus 100 may be oriented such that the fluid 124 (*e.g*., external air flow) moves in the indicated direction over the wall 102.

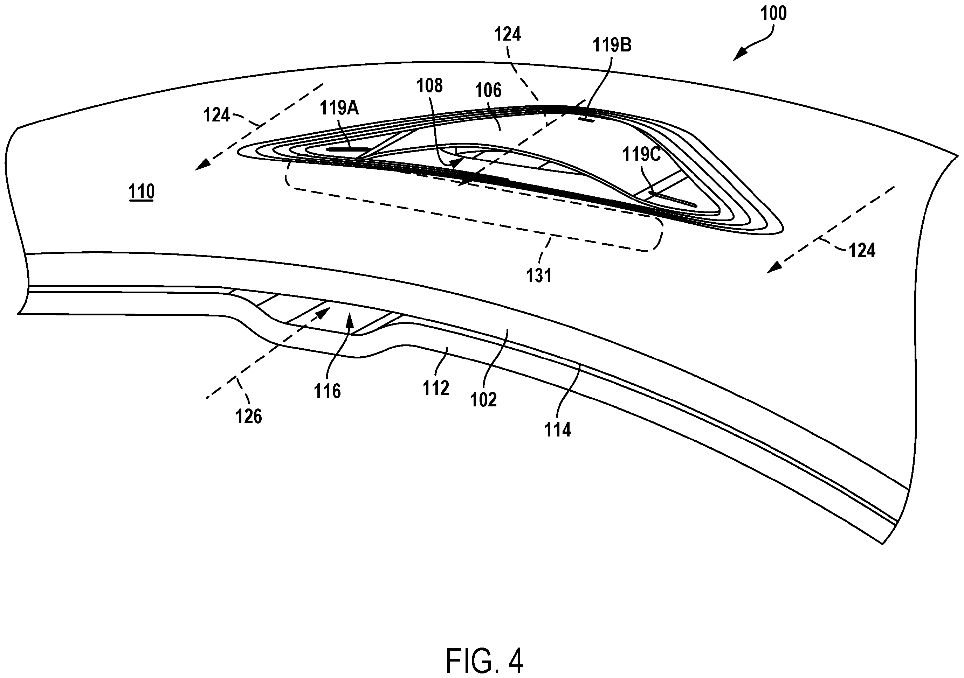

Figure 4 is a view of the panel 106 in an open position. The apparatus 100 may optionally include a lining 112 attached to the side 114 of the wall 102. The lining 112 may be attached to the side 114 via fasteners or adhesives, but other examples are possible. The lining 112 may be made from heat-resistant foam or the like, or any materials that make up the wall 102.

For example, the lining 112 may include materials such as titanium, nickel-titanium sheet stock, nitinol, fabric batting, high-temperature insulation wool (HTIW), alkaline earth silicate wool (AES wool), alumina silicate wool (ASW), or polycrystalline wool (PCW). In some examples, the lining 112 may have pleated channels stiffened with a titanium mesh or a sprayed-on high-temperature silicone mesh.

The lining 112 may form a channel 116 for a fluid 126 to flow between the lining 112 and the wall 102. For example, heat may be generated within a compartment at least partially enclosed by the apparatus 100. The generated heat may be absorbed by the fluid 126. When the panel 106 is in the open position as shown in Figure 4, the heated fluid 126 may flow through the channel 116, and through the opening 104 via the path 108 opened by the panel 106 moving away from the wall 102. The panel 106 may be configured to move away from the wall 102 via at least a partial change in crystal phase caused by increasing temperature, as further described below.

In Figure 4, the panel 106 is shown attached to the wall 102 via three fasteners 119A, 119B, and 119C, but other examples are possible. In addition to attaching the panel 106 to the wall 102, one or more of the fasteners 119A-C may provide stress relief areas for the panel 106.

The fasteners 119A and 119C may take the form of shoulder bolts to allow some movement (e.g., strain relief) of the panel 106. In another example, the fasteners 119A and 119C may take the form of clamping fasteners.

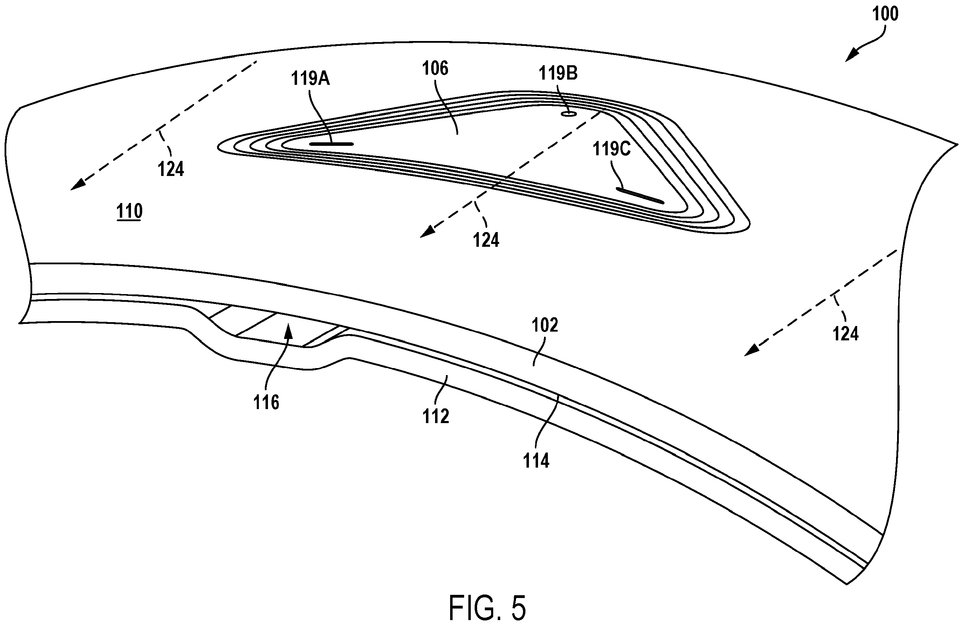

Figure 5 is a view of the panel 106 in a closed position. In the closed position, the panel 106 may substantially seal the opening 104, thereby narrowing or substantially eliminating the path 108 for the fluid 126 to flow through. The panel 106 may be configured to move toward the wall 102 via at least a partial change in crystal phase caused by decreasing temperature, as further described below.

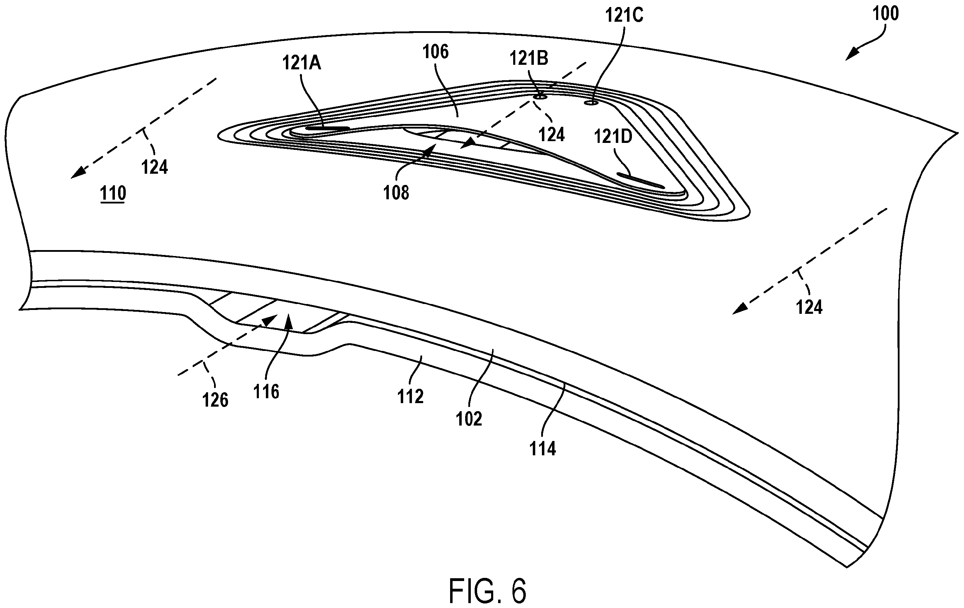

Figure 6 is another view of the panel 106 in an open position. In Figure 6, the panel 106 is attached to the wall 102 via four fasteners 121A, 121B, 121C, and 121D. In addition to attaching the panel 106 to the wall 102, one or more of the fasteners 121A-D may provide stress relief areas for the panel 106.

The fasteners 121A and 121D may take the form of shoulder bolts to allow some movement (*e.g*., strain relief) of the panel 106. In another example, the fasteners 121A and 121D may take the form of clamping fasteners.

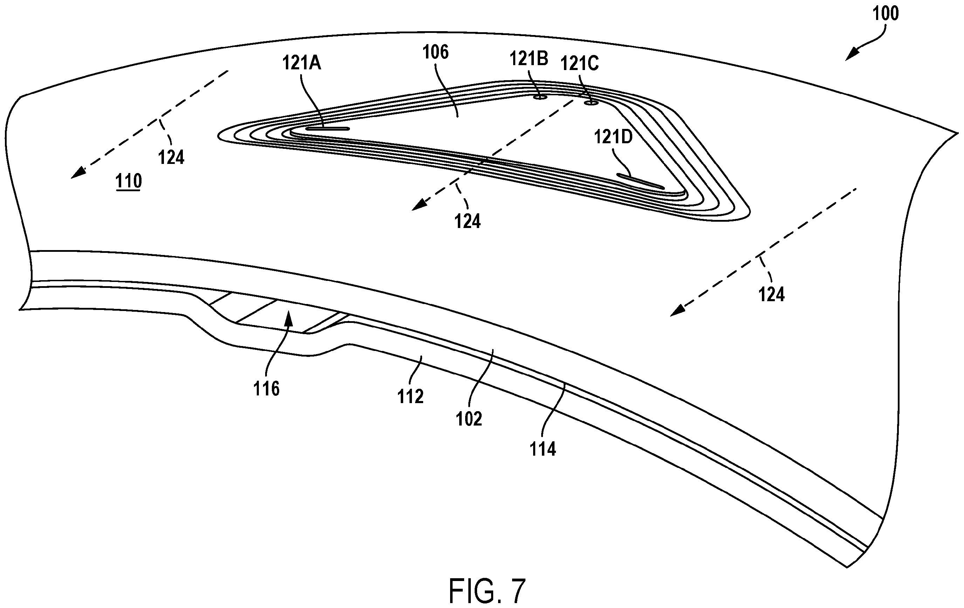

Figure 7 is another view of the panel 106 in a closed position. In Figure 7, the panel 106 is attached to the wall 102 via the four fasteners 121A-D.

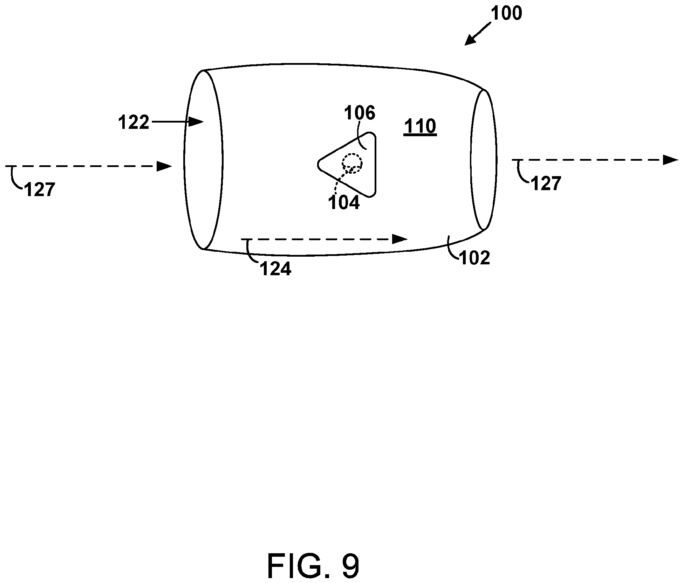

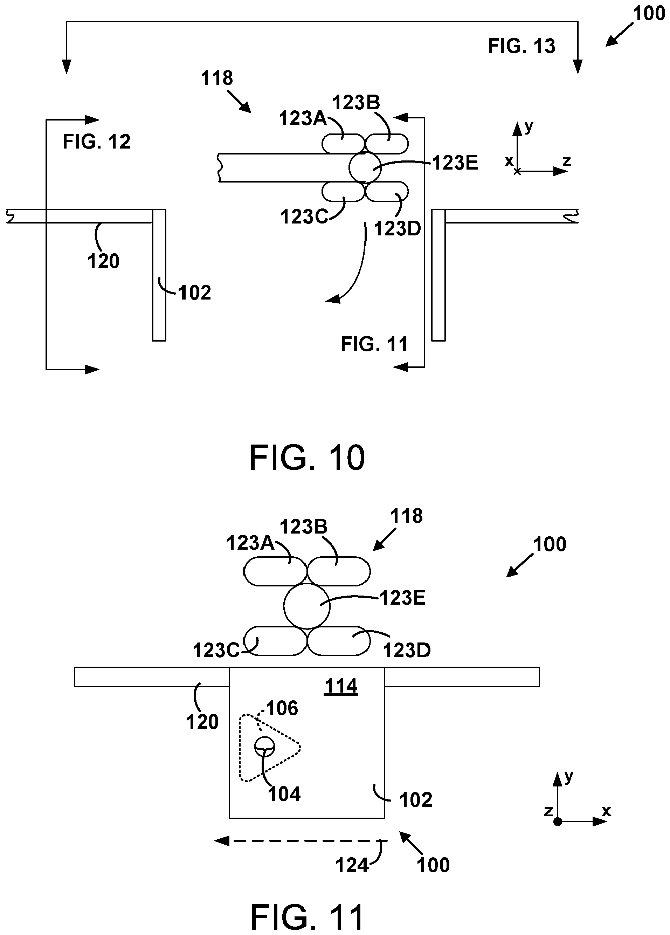

Figure 8 is a schematic diagram of the aircraft 120. The aircraft 120 may take the form of a wide-body twin-engine jet airliner, but other examples are possible. The aircraft 120 may include one or more instances of the apparatus 100. The apparatus 100 may further include landing gear 118 of the aircraft 120 or may include an engine 122 of the aircraft 120. A first instance of the apparatus 100 may be configured to at least partially enclose the engine 122 within the aircraft 120 as shown in Figure 9. A second instance of the apparatus 100 may be configured to at least partially enclose the landing gear 118 within the aircraft 120 as shown in Figures 10-13.

Figure 9 illustrates the apparatus 100 forming a portion of an engine compartment that at least partially encloses the engine 122 (*e.g.,* a jet engine). The engine 122 may include one or more fans, compressors, combustors, turbines, mixers, or nozzles that function in concert to produce thrust for the aircraft 120. In the example illustrated by Figure 9, the wall 102 may have a tubular form and may at least partially enclose or surround the engine 122. The engine 122 may draw fluid 127 (*e.g.,* air) into a front end of the apparatus 100 and expel the fluid 127 from a back end of the apparatus 100. In some situations, the engine 122 may provide reverse thrust and the fluid 127 may travel in a direction that is opposite the direction indicated by Figure 9.

The panel 106 may be configured to open or close the opening 104 depending on the positioning of the panel 106. In the open position, the panel 106 may allow fluid heated by the engine 122 within the wall 102 to escape outside the wall 102 through the opening 104. In the closed position, the panel 106 may reduce, restrict, or stop fluid flow through the opening 104, but may form part of an aerodynamic external surface on the side 110 of the wall 102.

Figure 10 illustrates a rear view of the apparatus 100 forming a portion of a landing gear compartment. In the example of Figure 10, the apparatus 100 may include the landing gear 118 of the aircraft 120. The landing gear 118 may include four wheels 123A, 123B, 123C, and 123D, and a support 123E. In other examples, the landing gear 118 may include any number of wheels. The support 123E may be attached to another structural member (not shown) of the aircraft 120. The wall 102 may form a portion of a landing gear door that is in an open position underneath the aircraft 120 as shown in Figure 10. During landing, the landing gear 118 may be deployed underneath the aircraft 120 while one or more landing gear doors are opened.

Figure 11 is a side view of the apparatus 100 shown in Figure 10. In Figure 11, the wall 102 takes the form of a landing gear door that is opened downward below the aircraft 120 to show the side 114 of the wall 102, the opening 104, and the panel 106. The panel 106 is shown with dashed lines to indicate that the panel 106 is behind the wall 102 with respect to the perspective of Figure 11. A typical direction of flow of the fluid 124 (*e.g.,* external air flow) is as indicated.

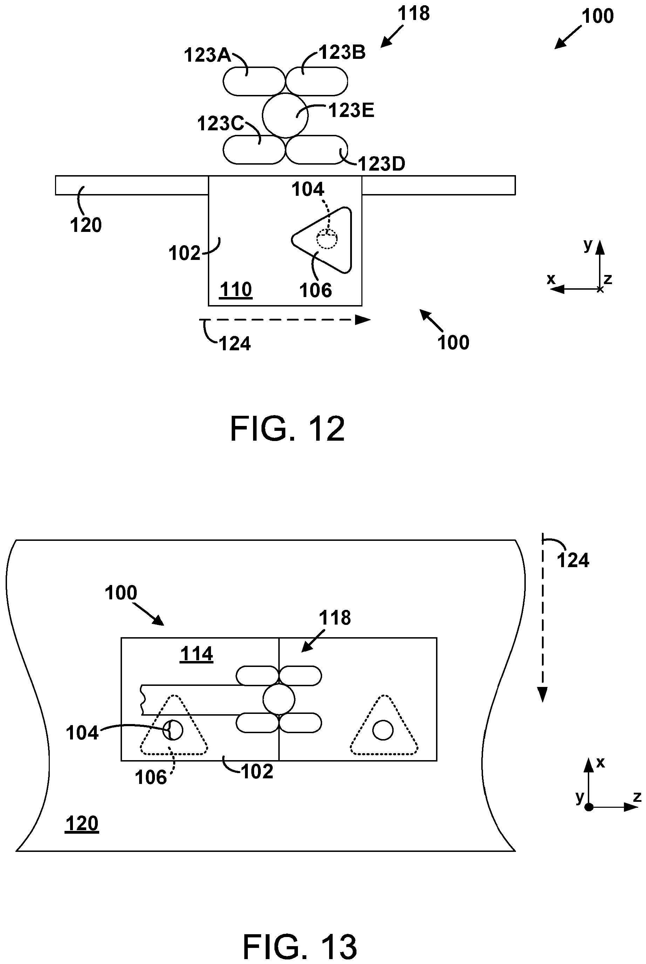

Figure 12 is another side view of the apparatus 100 shown in Figures 10 and 11. In Figure 12, the wall 102 takes the form of a landing gear door that is opened downward below the aircraft 120 to show the side 110 of the wall 102, the opening 104, and the panel 106. The opening 104 is shown with dashed lines to indicate that the opening 104 is behind the panel 106 with respect to the perspective of Figure 12. A typical direction of flow of the fluid 124 (*e.g.,* external air flow) is as indicated.

Figure 13 is a downward view of the apparatus 100 shown in Figures 10-12. In Figure 13, the wall 102 takes the form of a landing gear door that is closed to at least partially enclose the landing gear 118. The panel 106 is shown with dashed lines to indicate that the panel 106 is behind the wall 102 with respect to the perspective of Figure 13. A typical direction of flow of the fluid 124 (*e.g*., external air flow) is as indicated.

When the wall 102 is in the closed position such that the wall 102 at least partially encloses the landing gear 118, the apparatus 100 may be configured to provide either a path through the opening 104 for heat transfer via fluid flow from the side 114 to the side 110, or an outward-facing aerodynamic surface that includes the panel 106 and the side 110.

In some instances, components of the devices and/or systems described herein are configured to perform functions described herein such that the components are actually configured and structured to enable such performance. In other examples, components of the devices and/or systems may be arranged to be adapted to, capable of, or suited for performing the functions, such as when operated in a specific manner.

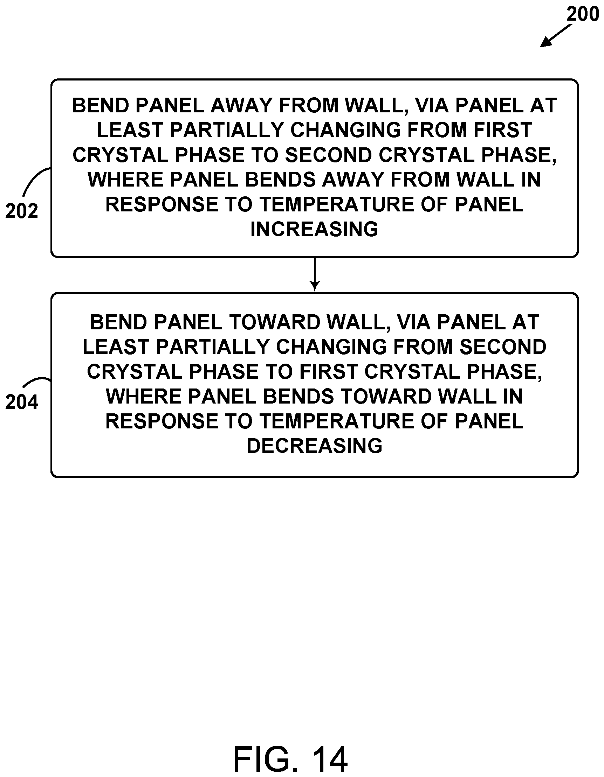

Figure 14 is a block diagram of a method 200 for actuating a panel that is attached to a wall over an opening in the wall.

At block 202, the method 200 includes bending the panel away from the wall, via the panel at least partially changing from a first crystal phase to a second crystal phase. The panel may bend away from the wall in response to a temperature of the panel increasing.

For example, the panel 106 of Figures 1, 3-7, and 9-13 may bend away from (*e.g.,* pop up from) the wall 102 via the panel 106 at least partially changing from a first crystal phase to a second crystal phase. For instance, in Figure 5 the panel 106 is shown in a closed position. As the temperature of the panel increases (*e.g*., exceeds a threshold temperature), the panel 106 may at least partially change from a first crystal phase to a second crystal phase. More specifically, some or all portions of the panel 106 may make the transition from the first crystal phase to the second crystal phase, thereby transitioning to an open position depicted in Figures 4 and 6.

The panel 106 may at least partially change from the first crystal phase to the second crystal phase due to the temperature of the panel 106 increasing. For example, heat generated within an engine compartment or within a landing gear compartment of the aircraft 120 may cause the temperature of the panel 106 to increase. The change in crystal phase may cause internal stresses within the panel 106, thereby causing the panel 106 to relieve the induced stress by changing shape and bending away from the wall 102. More specifically, the panel 106 may bend away from the wall 102 in response to the temperature of the panel 106 exceeding a predetermined threshold temperature such as 100° C. Depending on various SMMs that may be included as part of the panel 106, the panel 106 may bend away from the wall 102 in response to the temperature of the panel 106 exceeding other threshold temperatures as well.

As shown in Figures 4 and 6, the panel 106 bending away from the wall 102 may open a path 108 or widen the path 108 for the fluid 126 to flow through the opening 104. The fluid 126 may include fluid heated within an engine compartment or a landing gear compartment of the aircraft 120, for example.

At block 204, the method 200 includes bending the panel toward the wall, via the panel at least partially changing from the second crystal phase to the first crystal phase. The panel may bend toward the wall in response to the temperature of the panel decreasing.

For example, the panel 106 of Figures 1, 3-7, and 9-13 may bend back toward the wall 102 via the panel 106 at least partially changing from the second crystal phase to the first crystal phase. For instance, in Figures 4 and 6 the panel 106 is shown in an open position. As the temperature of the panel decreases (*e.g*., decreases to be less than a threshold temperature), the panel 106 may at least partially change from the second crystal phase back to the first crystal phase. More specifically, some or all portions of the panel 106 may make the transition from the second crystal phase to the first crystal phase.

The panel 106 may at least partially change from the second crystal phase to the first crystal phase due to the temperature of the panel 106 decreasing. While the panel 106 is in the open position, heat generated within an engine compartment or within a landing gear compartment of the aircraft 120 may escape through the opening 104, which may cause the temperature of the panel 106 to decrease over time. The change in crystal phase may cause internal stresses within the panel 106, thereby causing the panel 106 to relieve the induced stress by changing shape and bending toward the wall 102. More specifically, the panel 106 may bend toward the wall 102 in response to the temperature of the panel 106 decreasing to be less than a predetermined threshold temperature such as 100° C. Depending on various SMMs that may be included as part of the panel 106, the panel 106 may bend toward the wall 102 in response to the temperature of the panel 106 decreasing to be less than other threshold temperatures as well.

In some examples, the panel 106 may exhibit hysteresis, in that the threshold temperature (*e.g.,* 105° C) at which the panel changes from the first crystal phase to the second crystal phase is greater than the temperature (*e.g*., 95° C) at which the panel changes from the second crystal phase to the first crystal phase. This may be beneficial in that the panel 106 may stay in the open position for a longer amount of time, allowing more heat to escape from behind the wall 102 before the panel 106 transitions back to the first crystal phase and restricts such fluid or heat flow.

As shown by comparing Figures 3, 5, and 7 to Figures 4 and 6, the panel 106 bending toward the wall 102 may seal the path 108 or narrow the path 108, restricting the flow of the fluid 126 through the opening 104. As such, bending the panel 106 toward the wall 102 may occur such that the panel 106 is flush with a surface (*e.g.* side 110) of the wall 102 or such that the panel 106 substantially returns to a position at which the panel assumed prior to bending the panel 106 away from the wall 102 in response to the temperature of the panel 106 increasing. More specifically, the panel 106 may, due to an increase in temperature of the panel 106, transition from the closed position depicted in Figure 5 to the open position depicted in Figure 4. Subsequently, the panel 106 may, due to a decrease in the temperature of the panel 106, transition from the open position depicted in Figure 4 back to the closed position depicted in Figure 5.

In some examples, the fluid 126 may flow through a channel 116 of a lining 112 that is attached to the side 114 of the wall 102.

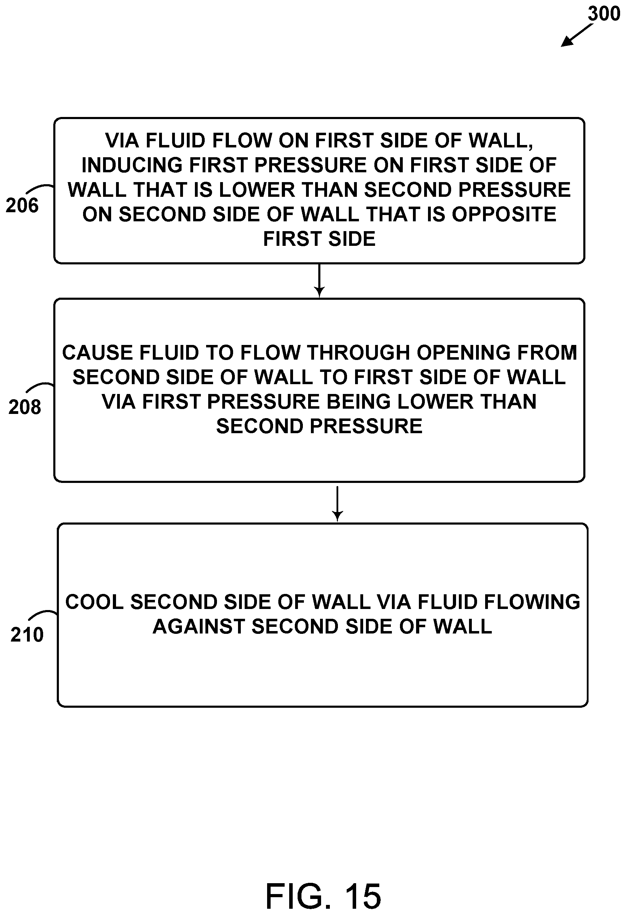

Figure 15 is a block diagram of a method 300 that may be used in conjunction with the method 200.

At block 206, the method 300 includes, via fluid flow on a first side of the wall, inducing a first pressure on the first side of the wall that is lower than a second pressure on a second side of the wall that is opposite the first side.

At block 208, the method 300 optionally includes causing the fluid to flow through the opening from the second side of the wall to the first side of the wall via the first pressure being lower than the second pressure.

At block 210, the method 300 optionally includes cooling the second side of the wall via the fluid flowing against the second side of the wall.

Referring to Figure 4 for example, the fluid 124 (*e.g.,* external air) may flow over the panel 106 in the direction indicated. The flowing fluid 124 may induce a venturi effect or a pressure differential between the side 110 of the wall 102 and the side 114 of the wall 102. That is, the pressure at an area roughly defined by region 131 may be lower than a pressure that exists on the side 114 of the wall 102. As such, the flowing fluid 124 and/or the induced pressure differential may draw the fluid 126 through the channel 116, increasing the rate of the fluid 126 that may flow from the side 114 to the side 110 through the opening 104. It should be noted that the channel 116 and the lining 112 are not required for the fluid 124 to generate the pressure differential that draws the fluid 126 through the opening 104. The venture effect or pressure differential may be generated simply by the velocity of the fluid 124 being greater than the velocity of the fluid 126.

The fluid 126 flowing and escaping an engine compartment or a landing gear compartment of the aircraft 120 may cool the side 114 of the wall 102 and other structures or components within the engine compartment of landing gear compartment.

Further embodiments of the invention are set out in the following clauses.
A1. An apparatus comprising:
   a wall having an opening; and
   a panel attached to the wall over the opening, wherein the panel comprises a shape-memory material (SMM), and wherein the panel bends away from the wall in response to an increase in a temperature of the panel and bends toward the wall in response to a decrease of the temperature of the panel.
A2. The apparatus of clause A1, wherein the SMM comprises a shape-memory alloy or a shape-memory polymer.
A3. The apparatus of clause A1 or A2, wherein the panel bends away from the wall to open a path or widen a path for a fluid to flow through the opening.
A4 The apparatus of any of clauses A1 to A3, wherein the panel bends away from the wall in response to the temperature of the panel exceeding a predetermined threshold temperature.
A5. The apparatus of any of clauses A1 to A4, wherein the panel bends toward the wall to seal the opening or narrow a path for a fluid to flow through the opening.
A6. The apparatus of any of clauses A1 to A5, wherein the panel bends toward the wall such that the panel is flush with a surface of the wall or such that the panel returns or substantially returns to a position at which the panel assumed prior to the panel bending away from the wall in response to the increase in the temperature of the panel.
A7. The apparatus of any of clauses A1 to A6, wherein the panel bends toward the wall in response to the temperature of the panel decreasing to be less than a predetermined threshold temperature.
A8. The apparatus of any of clauses A1 to A7, wherein the panel is attached to the wall on a first side of the wall, the apparatus further comprising:
   a lining attached to a second side of the wall that is opposite the first side, the lining forming a channel for a fluid to flow between the lining and the wall.
A9. The apparatus of any of clauses A1 to A8, further comprising landing gear of an aircraft, wherein the apparatus is configured to at least partially enclose the landing gear within the aircraft.
B1. An aircraft comprising the apparatus of any of clauses A1 to A9.
C1. An aircraft comprising:
   an engine;
   a wall having an opening, wherein the wall at least partially surrounds the engine; and
   a panel attached to the wall over the opening, wherein the panel comprises a shape-memory material (SMM), and wherein the panel bends away from the wall in response to an increase in a temperature of the panel and bends toward the wall in response to a decrease of the temperature of the panel.
D1. A method for actuating a panel that is attached to a wall over an opening in the wall, the method comprising:
   bending the panel away from the wall, via the panel at least partially changing from a first crystal phase to a second crystal phase, wherein the panel bends away from the wall in response to a temperature of the panel increasing; and
   bending the panel toward the wall, via the panel at least partially changing from the second crystal phase to the first crystal phase, wherein the panel bends toward the wall in response to the temperature of the panel decreasing.
D2 The method of clause D1, wherein bending the panel away from the wall comprises bending the panel away from the wall in response to the temperature of the panel exceeding a predetermined threshold temperature.
D3. The method of clause D1 or D2, wherein bending the panel away from the wall comprises opening a path or widening a path for a fluid to flow through the opening.
D4. The method of clause D3, wherein the panel is attached to the wall on a first side of the wall, the method further comprising:
   via fluid flow on the first side of the wall, inducing a first pressure on the first side of the wall that is lower than a second pressure on a second side of the wall that is opposite the first side.
D5. The method of clause D4, further comprising causing the fluid to flow through the opening from the second side of the wall to the first side of the wall via the first pressure being lower than the second pressure.
D6. The method of clause D5, wherein the fluid flows through a channel of a lining that is attached to the second side of the wall.
D7. The method of clause D6, further comprising cooling the second side of the wall via the fluid flowing against the second side of the wall.
D8. The method of any of clauses D1 to D7, wherein bending the panel toward the wall comprises bending the panel toward the wall in response to the temperature of the panel decreasing to be less than a predetermined threshold temperature.
D9 The method of any of clauses D1 to D8, wherein bending the panel toward the wall comprises sealing the opening or narrowing a path for a fluid to flow through the opening.
D10. The method of any of clauses D1 to D9, wherein bending the panel toward the wall comprises bending the panel toward the wall such that the panel is flush with a surface of the wall or such that the panel returns or substantially returns to a position at which the panel assumed prior to bending the panel away from the wall in response to the temperature of the panel increasing.

The description of the different advantageous arrangements has been presented for purposes of illustration and description, and is not intended to be exhaustive or limited to the embodiments in the form disclosed. Many modifications and variations will be apparent to those of ordinary skill in the art. Further, different advantageous embodiments may describe different advantages as compared to other advantageous embodiments. The embodiment or embodiments selected are chosen and described in order to explain the principles of the embodiments, the practical application, and to enable others of ordinary skill in the art to understand the disclosure for various embodiments with various modifications as are suited to the particular use contemplated.

## Claims

1. An apparatus comprising:
a wall having an opening; and
a panel attached to the wall over the opening, wherein the panel comprises a shape-memory material (SMM), and wherein the panel bends away from the wall in response to an increase in a temperature of the panel and bends toward the wall in response to a decrease of the temperature of the panel.

2. The apparatus of claim 1, wherein the panel bends away from the wall to open a path or widen a path for a fluid to flow through the opening.

3. The apparatus of claim 1 or 2, wherein:
the panel bends away from the wall in response to the temperature of the panel exceeding a predetermined threshold temperature, or
the panel bends toward the wall in response to the temperature of the panel decreasing to be less than a predetermined threshold temperature.

4. The apparatus of any of claims 1-3, wherein the panel bends toward the wall to seal the opening or narrow a path for a fluid to flow through the opening.

5. The apparatus of any of claims 1-4, wherein the panel bends toward the wall such that the panel is flush with a surface of the wall or such that the panel substantially returns to a position at which the panel assumed prior to the panel bending away from the wall in response to the increase in the temperature of the panel.

6. The apparatus of any of claims 1-5, wherein the panel is attached to the wall on a first side of the wall, the apparatus further comprising:
a lining attached to a second side of the wall that is opposite the first side, the lining forming a channel for a fluid to flow between the lining and the wall.

7. The apparatus of any of claims 1-6, further comprising landing gear of an aircraft, wherein the apparatus is configured to at least partially enclose the landing gear within the aircraft.

8. A method for actuating a panel that is attached to a wall over an opening in the wall, the method comprising:
bending the panel away from the wall, via the panel at least partially changing from a first crystal phase to a second crystal phase, wherein the panel bends away from the wall in response to a temperature of the panel increasing; and
bending the panel toward the wall, via the panel at least partially changing from the second crystal phase to the first crystal phase, wherein the panel bends toward the wall in response to the temperature of the panel decreasing.

9. The method of claim 8, wherein bending the panel away from the wall comprises bending the panel away from the wall in response to the temperature of the panel exceeding a predetermined threshold temperature.

10. The method of claim 8 or 9, wherein bending the panel away from the wall comprises opening a path or widening a path for a fluid to flow through the opening.

11. The method of claim 10, wherein the panel is attached to the wall on a first side of the wall, the method further comprising:
via fluid flow on the first side of the wall, inducing a first pressure on the first side of the wall that is lower than a second pressure on a second side of the wall that is opposite the first side.

12. The method of claim 11, further comprising causing the fluid to flow through the opening from the second side of the wall to the first side of the wall via the first pressure being lower than the second pressure.

13. The method of claim 12, wherein the fluid flows through a channel of a lining that is attached to the second side of the wall and, optionally, cooling the second side of the wall via the fluid flowing against the second side of the wall.

14. The method of any of claims 8-13, wherein bending the panel toward the wall comprises bending the panel toward the wall in response to the temperature of the panel decreasing to be less than a predetermined threshold temperature.

15. The method of any of claims 8-14, wherein bending the panel toward the wall comprises bending the panel toward the wall such that the panel is flush with a surface of the wall or such that the panel substantially returns to a position at which the panel assumed prior to bending the panel away from the wall in response to the temperature of the panel increasing.
